Europäisches Patentamt

European Patent Office

Office européen des brevets

(19)

(11) **EP 1 553 813 A1**

(12) **EUROPEAN PATENT APPLICATION**
published in accordance with Art. 158(3) EPC

(43) Date of publication:
   **13.07.2005 Bulletin 2005/28**

(21) Application number: **03756616.3**

(22) Date of filing: **15.10.2003**

(51) Int Cl.[7]: **H05K 9/00**, F16F 15/08,
   C08J 9/28

(86) International application number:
   **PCT/JP2003/013175**

(87) International publication number:
   **WO 2004/036973 (29.04.2004 Gazette 2004/18)**

(84) Designated Contracting States:
   **AT BE BG CH CY CZ DE DK EE ES FI FR GB GR
   HU IE IT LI LU MC NL PT RO SE SI SK TR**
   Designated Extension States:
   **AL LT LV MK**

(30) Priority: **18.10.2002 JP 2002304328**

(71) Applicant: **Nisshinbo Industries, Inc.**
   **Chuo-ku, Tokyo 103-8650 (JP)**

(72) Inventors:
   • **TAKENISHI, Soichiro,**
   **c/o Nisshinbo Tempest Inc.**
   **Adachi-ku, Tokyo 123-8585 (JP)**

   • **SASAKI, Hajime, Nisshinbo Ind.,**
   **Tokushima Plant**
   **Tokushima 771-0187 (JP)**
   • **YOSHIMOTO, Mitsuhiko, Nisshinbo Ind;**
   **Tokushima Pt.**
   **Tokushima 771-0187 (JP)**

(74) Representative: **Müller-Boré & Partner**
   **Patentanwälte**
   **Grafinger Strasse 2**
   **81671 München (DE)**

(54) **CONDUCTIVE CUSHION MATERIAL AND PROCESS FOR PRODUCING THE SAME**

(57)    A conductive cushion material that can effectively shield electromagnetic wave leaking from a housing of an information device such as a cellular phone and also has a cushioning function to protect electronics parts comparatively fragile to impact, as well as a method for manufacturing the same, where manufacturing processes are simple and easy, are provided. More specifically, a conductive cushion material comprising a fiber aggregate (A) composed of conductive fine wires and an elastic resin (B) containing a conductive filler (C), **characterized in that** at least a part of edges of the fiber aggregate (A) is exposed out of the external surface of the cushion material, while the rest of the edges are embedded in the cushion material, and that the elastic resin (B) has many cavities therein, while uniformly mixed with the conductive filler (C), and a method for manufacturing the same are provided.

Figure 1

EP 1 553 813 A1

**Description**

BACKGROUND OF THE INVENTION

FIELD OF THE INVENTION

The present invention relates to a cushion material having a high electromagnetic wave shielding effect and high flexibility, and a method for manufacturing the same. In more detail, the present invention relates to a cushion material comprising a fiber aggregate, composed of conductive fine wires and an elastic resin having cavities and dispersed with a conductive filler, and a method for manufacturing the same.

DESCRIPTION OF THE PRIOR ART

Many electronics devices making use of electricity, electrons, radio wave, and the like have recently been prevalent owing to progress of electronics technology, with which higher frequency, digitalization and higher integration of electronics devices have significantly been progressing. Among these, some emit electromagnetic waves which have adverse effects on human beings and other devices and have recently noticed public attention. The prevention against electromagnetic wave interference has become extremely important.

Among various countermeasures against electromagnetic wave interference, a conductive material to be used as an electromagnetic wave shielding material, having electromagnetic wave shielding performance, is considered to be the most prominent candidate as a preventive measure. An electromagnetic wave shielding material is a material to be used for covering electronic devices, buildings, and the like to intercept both external and internal electromagnetic waves.

Generally, the following four approaches are typical and proposed in various ways in regard to technique for furnishing a polymer material such as plastics and rubber with electromagnetic wave shielding performance or conductivity.

(1) Technique to mix and disperse a conductive material into a polymer material such as plastics, rubber and foam materials (for example, see JP-A-7-249890 (claims, and the like))

(2) Technique to embed a conductor such as a metal or a conductive material in a polymer matrix (for example, see JP-A-10-237184 application (claims, and the like), JP-A-11-68376 (claims, and the like) and JP-A-2001-85888 (claims, and the like)).

(3) Technique to form a conduction route at polymer surface or inside areas by chemical plating or vapor deposition of a metal, and the like (for example, see JP-A-2002-164684 (claims, and the like)).

(4) Technique to plaster or laminate a highly conductive material at polymer surface (for example, see JP-A-6-85488 (claims, and the like)).

However, the above conventionally proposed techniques have various problems.

For example, in the case of the above technique (1) to mix and disperse a conductive material into a polymer material, for example, when carbon black is used as a conductive material, high filling ratio is required, and such high filling ratio to give high conductivity results in poor mechanical property. On the other hand, an expensive material such as silver is necessary to lower the filling ratio. A manufacturing method by impregnation also has a weak point of complicated manufacturing process.

In the case of the above technique (2) to embed a conductive material in a polymer matrix, when a mesh, a metal foil, an expanded metal, and the like are embedded, thickness thereof is restricted and sometimes anisotropy, generates, in other words, isotropy is lost, and conductivity varies depending on density of a mesh-like body, when used, in a polymer. High-density filling is required to obtain high conductivity, resulting in a weak point of losing cushioning property.

In the case of the above technique (3) of chemical plating or vapor deposition of a metal, a plated layer at a contact surface of a housing tends to drop off due to abrasion in cushioning action such as impact absorption, resulting in a weak point of difficulty in exerting stable performance over a long period.

In the case of the above technique (4) to plaster (or laminate) a highly conductive material on the surface of a polymer material such as, when a mesh of metal fine wires is plastered, cushioning of whole system is impaired due to lack of elasticity in a conductive layer. In addition, adherence at a contact part of a housing is impaired, resulting in a weak point that electromagnetic wave may easily leak.

Because conventionally proposed conductive materials for shielding electromagnetic wave have various problems as described above, a conductive cushion material that can overcome these problems and has superior shielding ability against electromagnetic wave has been strongly desired.

It is an object of the present invention to provide a conductive cushion material that can overcome the above problems involved in conventional conductive materials and can effectively shield electromagnetic wave leaking from a housing of an information device such as a cellular phone and also has a cushioning function to protect electronics parts comparatively fragile to impact, and a method for manufacturing the same, where manufacturing processes are simple and easy.

SUMMARY OF THE INVENTION

The inventors of the present invention have found, after extensive study to solve the above problems, that when a conductive cushion material was manufactured by impregnating a solution dissolving polyurethane containing conductive carbon black in a solvent, into a conductive sheet composed of metal fine wires and then molding in atmosphere of hot air humidified with steam, it has a high electromagnetic wave shielding effect as well as flexibility and superior cushioning function due to having many cavities (bubbles) therein. The present invention has been developed based on the above knowledge.

The first aspect of the present invention provides a conductive cushion material comprising a fiber aggregate (A) composed of conductive fine wires and an elastic resin (B) containing a conductive filler (C), characterized in that at least a part of edges of the fiber aggregate (A) is exposed out of the external surface of the cushion material, while the rest of the edges are embedded in the cushion material, and that the elastic resin (B) has many cavities therein, while uniformly mixed with the conductive filler (C).

The second aspect of the present invention provides the conductive cushion material according to the first aspect of the invention, characterized in that the above elastic resin (B) is polyurethane.

The third aspect of the present invention provides the conductive cushion material according to the first or second aspect of the invention, characterized in that the above fiber aggregate (A) has weight per unit area in the range of 1 to 0.005 (Kg/m$^2$).

The fourth aspect of the present invention provides the conductive cushion material according to the third aspect of the invention, characterized in that the above fiber aggregate (A) is composed of metal fine wires.

The fifth aspect of the present invention provides the conductive cushion material according to any one of the first to fourth aspects of the invention, characterized in that the above conductive filler (C) is carbon black.

The sixth aspect of the present invention provides the conductive cushion material according to the fifth aspect of the invention, characterized in that compounding amount of the carbon black is 20 to 40% by weight based on total weight of the above elastic resin (B) and the above carbon black.

The seventh aspect of the present invention provides a method for manufacturing the conductive cushion material according to any one of the first to sixth aspects of the invention, characterized by comprising the first step where an elastic resin solution is obtained by dissolving an elastic resin (B) in a solvent and added thereto a conductive filler (C), the second step where a fiber aggregate (A) composed of conductive fine wires is impregnated with the elastic resin solution and the third step where a solvent is removed from the elastic resin solution under high temperature and high humidity condition and cavities are formed in the elastic resin (B).

The eighth aspect of the present invention provides the method for manufacturing a conductive cushion material according to the seventh aspect of the invention, characterized in that the fourth step where a solvent is removed by soaking the conductive cushion material in water or hot water is further added after the above third step.

The ninth aspect of the present invention provides the method for manufacturing a conductive cushion material according to the seventh or eighth aspect of the invention, characterized in that the fifth step is further added, where the conductive cushion material is molded by a press or a hot press to adjust thickness and improve smoothness of the surface thereof.

As described above, the present invention relates to a conductive cushion material, and the like comprising a fiber aggregate (A) composed of conductive fine wires and an elastic resin (B) containing a conductive filler (C), characterized in that at least a part of edges of the fiber aggregate (A) are exposed out of the external surface of the cushion material, while the rest of the edges are embedded in the cushion material, and that the elastic resin (B) has many cavities therein, while uniformly containing the conductive filler (C), and the preferred embodiments include the followings:

    (1) The conductive cushion material of the first aspect of the present invention, characterized in that electric resistance is not higher than 50 (Ω/3 cm) as for conductivity, electromagnetic wave shielding performance is not less than 45 (db) in the range of 100 to 1,000 MHz and type A Durometer hardness is not higher than 30 as for flexibility.
    (2) The conductive cushion material of the forth aspect of the present invention, characterized in that the metal fine wires are brass fine wires.
    (3) The method for manufacturing a conductive cushion material of the seventh aspect of the present invention, characterized in that the high-temperature and high-humidity in the third step means atmosphere of hot air humidified with steam.

BRIEF DESCRIPTION OF THE DRAWING

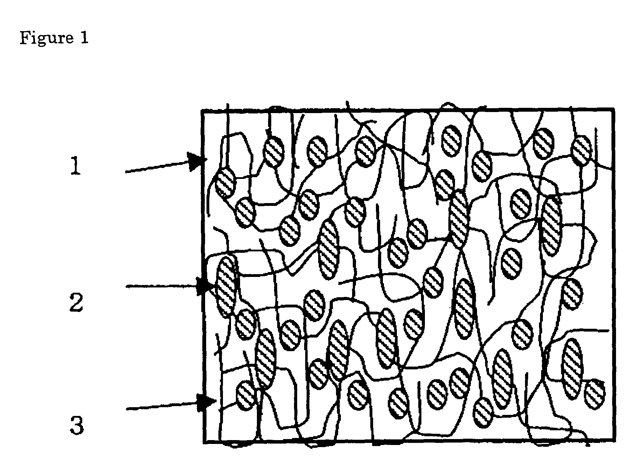

Figure 1 is a cross-sectional schematic drawing illustrating a conductive cushion material of the present invention.

NOTATION

1: an elastic resin dispersed with a conductive filler (fine particle)
2: cavity
3: a fiber aggregate (conductive fine wire)

DETAILED DESCRIPTION OF THE INVENTION

The present invention is described below in detail by each item.
The conductive cushion material of the present invention comprises a conductive cushion material comprising a fiber aggregate (A) composed of conductive fine wires and an elastic resin (B) containing a conductive filler (C), characterized in that at least a part of edges of the fiber aggregate (A) is exposed out of the external surface of the cushion material, while the rest of the edges are embedded in the cushion material, and that the elastic resin (B) has many cavities therein, while uniformly mixed with the conductive filler (C).

1. A Fiber Aggregate (A)

A fiber aggregate (A) in a conductive cushion material of the present invention is composed of conductive fine wires. Any conductive fine wires can be used, as appropriate, as long as it passes electricity, such as fiber having surface coated or painted with a conductive material, metal fine wires, carbon fiber, etc.
Among these, metal fine wires are more preferable because they have lower electric resistance and can provide higher conductivity. The metal fine wires include fine wires made of brass, copper, aluminum, stainless steel, etc.
Diameter of conductive fine wires is preferably not larger than 100 μm from the standpoint of cushion performance and electric resistance of a conductive cushion material.
Weight per unit area of a fiber aggregate is preferably in the range of 1 (Kg/m$^2$) to 0.005 (Kg/m$^2$). A fiber aggregate having weight lighter than 0.005 (Kg/m$^2$) does not express a conductivity effect and an electromagnetic wave shielding effect. On the other hand, weight over 1 (Kg/m$^2$) is not preferable because operability is impaired due to difficulty in impregnation with an elastic resin solution.
Thickness of a fiber aggregate may be varied depending on desired thickness of a conductive cushion material and is preferably in the range of 0.2 to 5 mm at standing.

2. An Elastic Resin (B)

Any resin that has elasticity can be used, as appropriate, as an elastic resin (B) in the present invention, which includes a polyurethane resin, a polyurethane urea resin, a silicone resin and an unvulcanized rubber material.
Among these, polyurethane is preferable because it is superior in mechanical properties and inexpensive and further has such advantage as desired properties, in particular, hardness can be easily modified by changing compounding ratio of raw materials composing polyurethane. Polyurethane is also preferable due to another advantage of a broad variety of solvent selection. This is because there are many solvents that can dissolve polyurethane and also water.
An unvulcanized rubber material to be used as an elastic resin may be subjected to a vulcanization reaction, while removing a solvent under high temperature and high humidity condition after adding a vulcanizing agent, a vulcanizing auxiliary, etc.

3. A Conductive Filler (C)

In the conductive cushion material of the present invention, a conductive filler (C) is added to improve conductivity of the above elastic resin (B). As a conductive filler, metal particles, carbon particles, and the like can be used as appropriate, however, carbon black, particularly acetylene black obtained from acetylene gas is preferable in view of conductivity and price.

4. A Conductive Cushion material and A Method for Manufacturing the Same

A conductive cushion material of the present invention that has superior electromagnetic wave shielding performance and a cushioning function can be obtained by following manufacturing methods. These manufacturing methods for such conductive cushion materials are characterized by comprising the following three (I - III), four (I - IV) or five (I - V) steps. The most dominant characteristics among these is the procedures comprising dissolving an elastic resin in a solvent, mixing thereto a conductive filler to obtain an elastic resin solution, impregnating the elastic resin solution into a fiber aggregate and then removing the solvent under high temperature and high humidity condition to prepare cavities in the elastic resin, while curing the resin.

(I) The first step where an elastic resin (B) is dissolved in a solvent to obtain an elastic resin solution mixed with a conductive filler (C) therein.
(II) The second step where the elastic resin solution obtained in the step I is impregnated into a fiber aggregate (A) composed of conductive fine wires.
(III) The third step where the fiber aggregate impregnated with the elastic resin solution obtained in the step II is deprived of the solvent under high temperature and high humidity condition to cure the elastic resin and form cavities in the elastic resin.
(IV) The fourth step where the conductive cushion material obtained in the step III is further soaked in water or hot water to remove the solvent.
(V) The fifth step where the conductive cushion material obtained in the step III or IV is molded by a press or a hot press to adjust thickness and improve smoothness of the surface thereof.

It is desirable that in a conductive cushion material of the present invention, a fiber aggregate (A) is embedded in a conductive material, that is, embedded in an elastic resin (B) containing a conductive filler (C), constituting said cushion material, and at least a part of edges of the embedded fiber aggregate of such as embedded metal fine wires is exposed out of the external surface of the cushion material, that is, exposed out of the external surface of elastic resin (B) (see Fig. 1).

In the conductive cushion material of the present invention, an elastic resin has many cavities therein to furnish a cushioning function. Shape or size of cavities visible by naked eye, among cavities contained in the elastic resin, are nearly spherical or oval-like, with short diameter of cavity about 0.3 to 1 mm.

These cavities can be formed by adding a foaming agent, etc. However, the above manufacturing method is preferable for furnishing a better cushioning function; that is, an elastic resin is dissolved in a solvent, followed by uniformly mixing with a conductive filler thereto to obtain an elastic resin solution, impregnating into a fiber aggregate and removing the solvent under high temperature and high humidity condition such as in hot air humidified with steam to cure the elastic resin, while forming cavities. It is also preferable to further remove the solvent by soaking an elastic resin in water or hot water after curing the elastic resin to some degree under high temperature and high humidity condition.

Any solvent can be used, as appropriate, without particular restriction in the manufacturing method of the conductive cushion material of the present invention, as long as it dissolves an elastic resin and is dissolved in water.

For example, when a urethane resin is used as an elastic resin, dimethylformamide (DMF), dimethylacetamide (DMAC), N-methyl-2-pyrrolidone (NMP), and the like can be suitably used. When a silicone resin is used as an elastic resin, tetrahydrofuran (THF), and the like can be used. In the case of an unvulcanized rubber material, acetone, methyl ethyl ketone (MEK), and the like can be used.

In an elastic resin solution containing a conductive filler (C) obtained in the step I in accordance with a manufacturing method of a conductive cushion material of the present invention, for example, when carbon black and polyurethane are used as a conductive filler and an elastic resin, respectively, the concentration of the solution dissolved with carbon black and polyurethane may be adjusted to concentration of a stock solution suitable for easy impregnation, although it depends on the mode of a conductive fiber aggregate. When the concentration of a stock solution is too low, a fiber aggregate is exposed too much after coagulation, and extremely thin layer of polyurethane containing carbon black generates, and thus not preferable. In contrast, when the concentration of a stock solution is too high, the solution is difficult to impregnate into a conductive fiber aggregate, resulting in presence of an uncoated layer of the conductive fiber aggregate, and thus not preferable either. Preferable concentration range of a stock solution (solution dissolving carbon black and polyurethane) is from 7 to 12% by weight.

Compounding amount of carbon black, as a conductive filler, may be determined according to desired conductivity performance of a conductive cushion material and is not particularly specified. However, too low compounding concentration of carbon black is not preferable due to lowering conductivity performance. In contrast, too high concentration of carbon black makes dispersion of the carbon black difficult and increase viscosity of a stock solution significantly, resulting in not only failure in obtaining an expected performance but may also impair operability or appearance of a conductive cushion material. Concentration of carbon black is preferably 20 to 40% by weight, more preferably 25 to 40% by weight based on total weight of the above elastic resin (B) and said carbon black for obtaining a conductive cushion material with suitable performance and quality.

One example (outline) of a specific manufacturing method of a conductive cushion material will be explained. A sheet of brass fine wires as a fiber aggregate (A), polyurethane as an elastic resin (B) and carbon black as a conductive filler (C) are used. A method for manufacturing a conductive cushion material of the present invention is not limited to this example.

(1) Preparation of A Polyurethane Solution (the first half I of the first step)

A solution (concentration: 15% by weight) of ether-based polyurethane pellets in DMF (dimethylformamide) is prepared using a kneader. After completion of dissolving, another DMF is added to prepare a 10% (by weight) polymer solution.

(2) Preparation of Conductive Carbon Black Dispersion Liquid (the first half II of the first step)

A solution of 10% (by weight) of conductive carbon black in DMF is prepared. A homogenizer is used for dispersing.

(3) Preparation of A Polyurethane Solution Containing Conductive Carbon Black (the first step)

The above polyurethane solution and conductive carbon black dispersion liquid are weighed and mixed to prepare a polyurethane solution containing conductive carbon black. The mixing ratio is, for example, 30 parts by weight of conductive carbon black dispersion liquid based on 70 parts by weight of the polyurethane solution. After mixing by stirring, the solution is left for an hour for natural defoaming and subjected to the next step.

(4) Manufacturing of A Conductive Cushion Material (the second, third and fourth steps)

A sheet of brass fine wires is degreased and washed with methylene chloride, if necessary. The dried sheet of brass fine wires is transferred in a vat and the above polyurethane solution containing conductive carbon black is charged to impregnate said polymer solution into the sheet of fine wires (the second step).

The vat is then placed in atmosphere of hot air humidified with steam ($90°C \times 50$ RH%). After solvent removal and solidification proceed, the vat is taken out and water is added to promote further solvent removal. After soaking in water for about 12 hours, the content is aerated and dried to obtain a conductive cushion material (the third and fourth steps).

A cross-sectional schematic drawing of thus manufactured conductive cushion material is shown in Figure 1. A fiber aggregate composed of conductive fine wires is embedded in polyurethane matrix dispersed with conductive fine particles (for example, carbon black) and at least a part of the embedded fiber aggregate is exposed out of the external surface of the cushion material. In addition, bubbles or cavities are formed by molding under high temperature and high humidity condition, that is, in atmosphere of hot air humidified with steam. Presence of the bubbles (cavities) furnishes elasticity, along with a synergetic effect for cushion performance.

A conductive cushion material of the present invention has Type A Durometer hardness of about 20 to 30, electric resistance of not higher than 50 ($\Omega$/3 cm) as conductivity and electromagnetic wave shielding performance of about 45 (db) in the range of 100 to 1,000 MHz.

By embedding a conductive fiber aggregate in a cushion material, that is, an elastic resin constituting the cushion material, the conductive cushion material of the present invention can possess mechanical characteristics of a fiber aggregate, resulting in improved mechanical properties similar to those of FRP (U) (fiber reinforced plastics (urethane resin)). On the other hand, when a conductive additive is mixed into an elastic resin without using a fiber aggregate, an increased mixing ratio of the conductive additive is required to obtain sufficient conductivity, resulting in impairing performance of an elastic resin.

In addition, by a conductive fiber aggregate having three-dimensionally incorporated structure in an elastic resin, stable conductivity is obtained at the surface and in the directions of thickness, length and width, that is, isotropic conductivity. In contrast, when a two-dimensional conductive material such as metal foil is embedded, sufficient conductivity can not be obtained in thickness direction, although it depends on thickness of the final product, thickness and number of layers of metal foils. Said method not only provides a cushion material without elasticity but also makes manufacturing difficult.

Bearing the above performance, a conductive cushion material of the present invention can effectively shield an electromagnetic wave leaking from a housing of an information device such as a cellular phone and also has a cushioning function to protect electronics parts comparatively fragile to impact, leading to suitable applications, for example, a cushioning material to protect liquid crystal of a cellular phone.

EXAMPLES

The present invention is described in more detail by EXAMPLES and COMPARATIVE EXAMPLES, which by no means limit the present invention.

(EXAMPLES 1 to 17, COMPARATIVE EXAMPLES 1 to 3)

Methods for manufacture and performance evaluation of the conductive cushion materials of EXAMPLES 1 to 17 and COMPARATIVE EXAMPLES 1 to 3 are described below. A sheet of brass fine wires as a fiber aggregate (A), polyurethane as an elastic resin (B) and carbon black as a conductive filler (C) are used.

1. Manufacturing of A Conductive Cushion Material

(1) Preparation of A Polyurethane Solution

Ether-based polyurethane pellets (trade name: MOBILON P-24TS from Nisshinbo Industries Inc.) of 350 (g) and N,N-dimethylformamide (DMF) of 1,983 (g) were charged in a kneader with a jacket and subjected to dissolving at 50°C for 2 hours. Polymer concentration in the polymer solution was about 15% (by weight). After the addition of 2,667 (g) of DMF, and further dissolving at 50°C for 2 hours, a 7% (by weight) polymer solution was obtained. Hereinafter, when changing polymer concentration in a polymer solution, a polymer solution of about 15% (by weight) was prepared by the above procedures and then diluted so that total weight of 5,000 (g) is obtained in the desired concentration of the final polymer solution.

(2) Preparation of Conductive Carbon Black Dispersion Liquid

Conductive carbon black (trade name: DENKA Black HS-100 from Denki Kagaku Kogyo K.K.) of 50 (g) was added with DMF of 664.3 (g) and dispersed with a homogenizer for 15 minutes to prepare a carbon black solution of 7% (by weight) concentration. The concentration of a carbon black solution was adjusted according to the concentration of a polymer solution to be used to prepare a composite.

(3) Preparation of A Polyurethane Solution Containing Conductive Carbon Black

A 7% (by weight) polymer solution of 140 (g) was added with a 60 (g) carbon black solution in a 500 (ml) separable flask and stirred at room temperature for 15 minutes. The polymer solution containing carbon black was left for standing for 60 minutes after completion of stirring for natural defoaming of incorporated foam in the polymer solution containing carbon black.

(4) Manufacture of A Conductive Cushion Material

An aggregate of brass lines (hereinafter, referred to as brass sheet) was used to prepare a cushion material, after degreasing or washing with methylene chloride, if necessary. A brass sheet having component brass lines of about 50 ($\mu$m) in diameter (hereinafter, referred to as wire diameter) and weight per 1 square meter (hereinafter, referred to as unit weight) of about 400 (g/m$^2$) was used. The brass sheet was cut into a square with sides of about 50 (mm) and placed in a tray (size: 300 mm $\times$ 210 mm $\times$ 37 mm) made of polypropylene. Subsequently, 100 (g) of a polymer solution containing carbon black was weighed and charged and foam accompanying the brass sheet was removed by shaking the sheet with a pincette.

The tray made of polypropylene loaded with the brass sheet and the polymer solution containing carbon black was then floated in a tray (size: 600 mm $\times$ 300 mm $\times$ 120 mm) made of stainless steel, filled with 3 (l) of warm water at about 60 (°C). Solvent removal and solidification were performed by heating and humidifying the whole tray in atmosphere of 90 (°C) and 50 (RH%) relative humidity for about 60 minutes. The solidified conductive cushion material was soaked in water for not shorter than about 12 hours and then air dried. A conductive cushion material was prepared

EP 1 553 813 A1

in this way.

2. Performance Evaluation

(1) Appearance and Presence of Cavities

Appearance of a conductive cushion material was evaluated by naked eye inspection, based on the following evaluation criteria. Presence of the cavities in a conductive cushion material was also judged by naked eye inspection.

⊚ : Brass fine wires are exposed and the surface of polyurethane part containing carbon black is approximately flat.
○: Brass fine wires are exposed and the surface of polyurethane part containing carbon black is approximately flat, with exception of some dents.
△: Brass fine wires are exposed and the surface of polyurethane part containing carbon black is approximately flat, with exception of somewhat prominent dents.
✕ : Some parts of brass fine wires are not coated with polyurethane part containing carbon black (non-coated parts)

(2) Hardness

Hardness of a conductive cushion material was measured according to JIS K7215 "Testing Methods for Durometer Hardness of Plastics".
The approximate acceptance standard on hardness is low hardness and Type A Durometer hardness of about 20 to 30 for a cushion material before hot press.

⊚ : not higher than 30 in Type A hardness
○: over 30 and not higher than 40 in Type A hardness
△: over 40 and not higher than 50 in Type A hardness
✕ : over 50 in Type A hardness

(3) Conductivity (Electric Resistance)

Electric resistance was measured for each of an open surface (the surface not contacted with a vat during preparation: hereinafter, referred to as a front surface) and a container contacting surface (the surface contacted with a vat: hereinafter, referred to as a back surface) of a conductive cushion material, with a digital multimeter (CDM-11HD Model, from Custom Inc.). A sample of a cushion material to be used in the measurement was cut into a square with sides of 50 (mm) and marked at every 10 (mm) on the periphery 10 (mm) inside from the outer periphery. Resistance value was measured by pressing one test lead on a point near an arbitrary mark and another test lead on a counter point (measurement spacing was 30 mm in this case). Total 8 data for one sample were obtained by measuring the resistance values between points near various marks and counter points thereof one after another to evaluate using average value thereof. Resistance value was measured for both front and back surfaces of a sample and each recorded independently.
A rough acceptance standard is low surface electric resistance, that is, electric resistance of not higher than 50 ($\Omega$/3 cm) for both surfaces. The best value is 1 to 3 ($\Omega$/3 cm).

⊚ : electric resistance value not higher than 10 ($\Omega$/3 cm)
○: electric resistance value over 10 and not higher than 50 ($\Omega$/3 cm)
△: electric resistance value over 50 and not more higher 1,000 ($\Omega$/3 cm)
✕ : electric resistance value over 1,000 ($\Omega$/3 cm)

(4) Electromagnetic Wave Shielding Performance

A blank level (E0) was measured first, without setting a sample in an electromagnetic wave shielding tester. A receiving level (E1) was then measured by setting a shielding material cut into a square with sides of 150 (mm) in the electromagnetic wave shielding tester (KEC method).
Shielding effect (S) was calculated using the following equation.

$$\text{Shielding effect (S)} = \text{(E0)} - \text{(E1): unit (db)}$$

The shielding effect was measured in a frequency range between 0.15 and 1,000 (MHz). A Model MA8602 made by Anritsu Corporation and a Model TR4173 made by Advantest Corporation were used as a electromagnetic wave shielding tester and a spectrum analyzer, respectively.

A rough acceptance standard is about 45 (db) of electromagnetic wave shielding performance between 100 and 1,000 (MHz).

⊚ : shielding effect of not less than 45 (db)
○: shielding effect of not less than 15 and less than 45 (db)
Δ: shielding effect of not less than 5 and less than 15 (db)
✕: shielding effect of less than 5 (db)

Example 1 was performed as described above, while for Example 13, types and compounding amounts of raw materials used are shown in Table 3, and the sample was prepared similarly as in Example 1, and further molded by a hot press.

In the molding method by hot press, an iron was used to hot press a conductive cushion material. Heating surface of an iron was set at 210 (°C) to be used for pressing for about 30 seconds horizontally against a conductive cushion material cut into a square with sides of 50 (mm).

In Comparative Example 1, a conductive cushion material was prepared by vacuum heating, and types and compounding amount of raw materials used are shown in Table 3. A method for preparation includes, preparation of a polymer solution, preparation of a carbon black solution and preparation of a polymer solution containing carbon black, similarly as in Example 1. Then, by the following method after the above steps, a conductive cushion material was prepared.

A brass sheet was used to prepare a cushion material after degreasing or washing with methylene chloride, if necessary. The brass sheet with brass line diameter of about 50 ($\mu$m) and weight per 1 square meter of about 100 (g/m$^2$) was used. The brass sheet was cut into a square with sides of about 50 (mm) and placed in a tray (size: 300 mm $\times$ 210 mm $\times$ 37 mm) made of polypropylene. Subsequently, 100 (g) of a polymer solution containing carbon black was weighed and charged, and foam accompanying the brass sheet was removed by shaking the sheet with a pincette. The tray made of polypropylene loaded with the above prepared material was then put in a vacuum drier and left at 50 (°C) under vacuum of 76 (cmHg) for 18 hours to evaporate a solvent, DMF.

For other Examples and Comparative Examples, types and compounding amount of raw materials are shown in Tables 1 to 3 and methods for preparation are similar as in Example 1.

Properties, and the like of thus obtained conductive cushion materials were evaluated. Compositions and property evaluation results of the conductive cushion materials are shown in Tables 1 to 3.

Table 1

| | | Example | | | | |
|---|---|---|---|---|---|---|
| Preparation | | 1 | 2 | 3 | 4 | 5 |
| Polymer solution preparation | | Change in fine lines (material) type | | | | |
| Polymername (polyurethane) | | P24TS | P24TS | P24TS | P24TS | P24TS |
| 1st & 2nd Solvent name | | DMF | DMF | DMF | DMF | DMF |
| Polymer weight | (parts) | 100 | 100 | 100 | 100 | 100 |
| 1st Solvent weight | (parts) | 567 | 567 | 567 | 567 | 567 |
| 2nd Solvent weight | (parts) | 762 | 762 | 762 | 762 | 762 |
| Total solvent weight | (parts) | 1329 | 1329 | 1329 | 1329 | 1329 |

Table 1   (continued)

| | | Example | | | | |
|---|---|---|---|---|---|---|
| Preparation | | 1 | 2 | 3 | 4 | 5 |
| CB-dispersion liquid preparation | | | | | | |
| CB name | | HS100 | HS100 | HS100 | HS100 | HS100 |
| Solvent name | | DMF | DMF | DMF | DMF | DMF |
| CB weight | (parts) | 100 | 100 | 100 | 100 | 100 |
| Solvent weight | (parts) | 1329 | 1329 | 1329 | 1329 | 1329 |
| Stock solution preparation | | | | | | |
| Polymer solution weight | (parts) | 100 | 100 | 100 | 100 | 100 |
| CB-Dispersing liquid weight | (parts) | 43 | 43 | 43 | 43 | 43 |
| CB Concentration | (% by weight) * | 30 | 30 | 30 | 30 | 30 |
| | | | | | | |
| Cushion material preparation | | | | | | |
| Conductive fine lines (CFL) type | | Brass | Aluminum | Stainless steel | Copper | Carbon felt |
| Unit weight of CFL sheet | $(kg/m^2)$ | 0.4 | 0.4 | 0.4 | 0.4 | 0.01 |
| Area of CFL sheet | $(cm^2)$ | 25 | 25 | 25 | 25 | 25 |
| Coated weight of stock solution | (g) | 100 | 100 | 100 | 100 | 100 |
| Solidification atmosphere | | Steam humidification | Steam humidification | Steam humidification | Steam humidification | Steam humidification |
| Hot Press | | None | None | None | None | None |
| | | | | | | |
| Evaluation result | | | | | | |
| Cavity | | Present | Present | Present | Present | Present |
| Appearance | | ○ | ○ | ○ | ○ | ○ |
| Hardness (type A hardness) | | ◎ | ◎ | ◎ | ◎ | ◎ |
| Electric Resistance | | ◎ | ○~Δ | ○~Δ | ◎ | ◎ |
| EMS Performance | | ◎ | ○ | ○ | ◎ | ○ |
| CB: Carbon Black | | | | | | |

Table 2

| | | Example | | | | | | |
|---|---|---|---|---|---|---|---|---|
| Preparation | | 6 | 7 | 8 | 9 | 10 | 11 | 12 |
| Polymer solution preparation | | Change in conc. of stock solution | | | Change in conc. of CB | | | |
| Polymer name (polyurethane) | | P24TS | P24TS | P24TS | P24TS | P24TS | P24TS | P24TS |
| 1st & 2nd Solvent name | | DMF | DMF | DMF | DMF | DMF | DMF | DMF |
| Polymer weight | (parts) | 100 | 100 | 100 | 100 | 100 | 100 | 100 |
| 1st Solvent weight | (parts) | 567 | 567 | 567 | 567 | 567 | 567 | 567 |
| 2nd Solvent weight | (parts) | 333 | 167 | 0 | 333 | 333 | 333 | 333 |
| Total solvent weight | (parts) | 900 | 733 | 567 | 900 | 900 | 900 | 900 |
| CB-dispersion liquid preparation | | | | | | | | |
| CB name | | HS100 | HS100 | HS100 | HS100 | HS100 | HS100 | HS100 |
| Solvent name | | DMF | DMF | DMF | DMF | DMF | DMF | DMF |
| CB weight | (parts) | 100 | 100 | 100 | 100 | 100 | 100 | 100 |
| Solvent weight | (parts) | 900 | 733 | 567 | 900 | 900 | 900 | 900 |
| Stock solution preparation | | | | | | | | |
| Polymer solution weight | (parts) | 100 | 100 | 100 | 100 | 100 | 100 | 100 |
| CB-Dispersing liquid weight | (parts) | 43 | 43 | 43 | 33 | 67 | 25 | 100 |

Table 2 (continued)

| | | Example | | | | | | |
|---|---|---|---|---|---|---|---|---|
| Preparation | | 6 | 7 | 8 | 9 | 10 | 11 | 12 |
| CB Concentration | (% by weight)* | 30 | 30 | 30 | 25 | 40 | 20 | 50 |
| | | | | | | | | |
| Cushion material preparation | | | | | | | | |
| Conductive fine lines (CFL) type | | Brass | Brass | Brass | Brass | Brass | Brass | Brass |
| Unit weight of CFL sheet | (kg/m$^2$) | 0.1 | 0.1 | 0.1 | 0.1 | 0.1 | 0.1 | 0.1 |
| Area of CFL sheet | (cm$^2$) | 25 | 25 | 25 | 25 | 25 | 25 | 25 |
| Coated weight of stock solution | (g) | 100 | 100 | 100 | 100 | 100 | 100 | 100 |
| Solidification atmosphere | | Steam humidification | Steam humidification | Steam humidification | Steam humidification | Steam humidification | Steam humidification | Steam humidification |
| Hot Press | | None | None | None | None | None | None | None |
| | | | | | | | | |
| Evaluation result | | | | | | | | |
| Cavity | | Present | Present | Present | Present | Present | Present | Present |
| Appearance | | ○ | ○ | ○ | ○ | ○ | ○ | Δ |
| Hardness(type A hardness) | | ◎ | ◎ | ◎ | ◎ | ◎ | ◎ | -*1 |
| Electric Resistance | | ◎ | ◎ | ◎ | ○ | ◎ | ○~Δ | ◎ |

EP 1 553 813 A1

Table 2   (continued)

| | | Example | | | | | | |
|---|---|---|---|---|---|---|---|---|
| Preparation | | 6 | 7 | 8 | 9 | 10 | 11 | 12 |
| EMS Performance | | ◎ | ◎ | ◎ | ◎ | ◎ | ○ | ◎ |
| Notes | | | | | | | | |

Table 3

| | | Example | | | | | Comparative Example | | |
|---|---|---|---|---|---|---|---|---|---|
| Preparation | | 13 | 14 | 15 | 16 | 17 | 1 | 2 | 3 |
| Polymer solution preparation | | Hot press | Change in unit weight of fine lines | | Change in coated weight of stock solution | | Vacuum heating | Metal lines alone | |
| Polymer name (polyurethane) | | P24TS | P24TS | P24TS | P24TS | P24TS | P24TS | - | P24TS |
| 1st & 2nd Solvent name | | DMF | DMF | DMF | DMF | DMF | DMF | - | DMF |
| Polymer weight | (parts) | 100 | 100 | 100 | 100 | 100 | 100 | - | 100 |
| 1st Solvent weight | (parts) | 567 | 567 | 567 | 567 | 567 | 567 | - | 567 |
| 2nd Solvent weight | (parts) | 167 | 167 | 167 | 333 | 333 | 167 | - | 333 |
| Total solvent weight | (parts) | 733 | 733 | 733 | 900 | 900 | 733 | - | 900 |
| CB-dispersion liquid preparation | | | | | | | | | |
| CB name | | HS100 | HS100 | HS100 | HS100 | HS100 | HS100 | - | HS100 |
| Solvent name | | DMF | DMF | DMF | DMF | DMF | DMF | - | DMF |
| CB weight | (parts) | 100 | 100 | 100 | 100 | 100 | 100 | - | 100 |
| Solvent weight | (parts) | 733 | 733 | 733 | 900 | 900 | 733 | - | 900 |
| Stock solution preparation | | | | | | | | - | |
| Polymer solution weight | (parts) | 100 | 100 | 100 | 100 | 100 | 100 | - | 100 |

EP 1 553 813 A1

Table 3   (continued)

| | | Example | | | | | Comparative Example | | |
|---|---|---|---|---|---|---|---|---|---|
| Preparation | | 13 | 14 | 15 | 16 | 17 | 1 | 2 | 3 |
| CB-Dispersing liquid weight | (parts) | 43 | 43 | 43 | 43 | 43 | 43 | - | 43 |
| CB Concentration | (% by weight) * | 30 | 30 | 30 | 30 | 30 | 30 | - | 30 |
| | | | | | | | | | |
| Cushion material preparation | | | | | | | | | |
| Conductive fine lines (CFL) type | | Brass | Brass | Brass | Brass | Brass | Brass | Stainless steel | |
| Unit weight of CFL sheet | (kg/m$^2$) | 0.1 | 0.2 | 0.05 | 0.1 | 0.1 | 0.1 | 0.05 | 0.1 |
| Area of CFL sheet | (cm$^2$) | 25 | 25 | 25 | 25 | 25 | 25 | - | 25 |
| Coated weight of stock solution | (g) | 100 | 100 | 100 | 50 | 150 | 100 | - | 300 |
| Solidification atmosphere | | Steam humidification | Steam humidification | Steam humidification | Steam humidification | Steam humidification | Vacuum heating | - | Brass |
| Hot Press | | Present | None | None | None | None | None | - | None |
| | | | | | | | | | |
| Evaluation result | | | | | | | | | |
| Cavity | | Present | Present | Present | Present | Present | None | - | Present |
| Appearance | | ◎ | ○ | ○ | ○ | ○ | ○ | - | ○ |
| Hardness (type A hardness) | | ○ | ◎ | ◎ | ◎ | ◎ | Δ | Impossible to measure | ◎ |

EP 1 553 813 A1

Table 3   (continued)

| | | Example | | | | | Comparative Example | | |
|---|---|---|---|---|---|---|---|---|---|
| Preparation | | 13 | 14 | 15 | 16 | 17 | 1 | 2 | 3 |
| Electric Resistance | | ◎ | ◎ | ◎ | ◎ | ◎ | ◎ | ◎ | Δ~× |
| EMS Performance | | ◎ | ◎ | ○ | ◎ | ◎ | ◎ | ○ | ○ |
| Notes | | | | | | | No Cushion | No use due to line scattering | Fine lines embedded |

As apparent from the above Tables 1 to 3, the conductive cushion materials obtained in Examples 1 to 17 are superior in hardness, conductivity, electromagnetic wave shielding performance and also appearance.

In contrast, the conductive cushion material of Comparative Example 1 prepared by molding using vacuum heating instead of steam humidifying has no cavity, resulting in high hardness and lack of flexibility (cushioning nature). A material made of brass fine wires alone in Comparative Example 2 was impossible to use due to scattering of the brass fine wires. Further in Comparative Example 3, where a large amount of a stock solution was used for coating, all the brass fine wires were embedded in a cushion material and electric resistance value did not attain acceptance standard. The reason is not clear, but may be estimated as follows. It is estimated that good conductive brass fibers entirely embedded means a thick layer of an elastic resin containing a conductive filler (carbon black) at the surface of a conductive cushion material, in other words, it makes a longer route with relatively high electric resistance in current pathway in measuring electric resistance. Consequently, it is considered that electric resistance of a conductive cushion material is determined by electric resistance of an elastic resin layer containing a conductive filler (that is, content of carbon black) and route length to the nearest metal fine wires (that is, thickness of a coated elastic resin containing carbon black on metal fine wires). In other words, when electric resistance of an elastic resin layer containing a conductive filler is low and coated thickness on metal fine wires is thin, electric resistance value of a conductive cushion material becomes low, that is preferable tendency. It is considered that a conductive cushion material of Comparative Example 3 did not attain the acceptance standard because it did not satisfy these requirements.

A conductive cushion material of the present invention can possess mechanical characteristics of a fiber aggregate and is superior in mechanical properties as well as conductivity and electromagnetic wave shielding performance, by placing and embedding a conductive fiber aggregate in three-dimensional state in a cushion material (that is, in an elastic resin) (but, at least a part of the fiber aggregate is exposed out of the external surface of the cushion material). In addition, a conductive cushion material of the present invention has stable conductivity at the surface thereof and in the directions of thickness, length and width thereof (that is, conductivity is isotropic), and hardly loses conductivity even by external force such as impact and friction.

A method for furnishing conductivity according to the present invention can provide sufficient conductivity for its use purpose, by combining industrially versatile materials (fiber aggregate and carbon black). In a manufacturing method of the present invention, a conductive cushion material can be manufactured continuously, inexpensively, easily and economically by coating a conductive fiber aggregate on a carrier with an elastic resin solution containing a conductive filler, using a coating machine on the market and then subjecting a precursor of the conductive cushion material on the carrier, to high temperature and high humidity and to a washing step with water.

**Claims**

1. A conductive cushion material comprising a fiber aggregate (A) composed of conductive fine wires and an elastic resin (B) containing a conductive filler (C), **characterized in that** at least a part of edges of the fiber aggregate (A) is exposed out of the external surface of the cushion material, while the rest of the edges are embedded in the cushion material, and that the elastic resin (B) has many cavities therein, while uniformly mixed with the conductive filler (C).

2. The conductive cushion material according to Claim 1, **characterized in that** said elastic resin (B) is polyurethane.

3. The conductive cushion material according to Claim 1 or 2, **characterized in that** said fiber aggregate (A) has weight per unit area of 1 to 0.005 (Kg/m$^2$).

4. The conductive cushion material according to Claim 3, **characterized in that** said fiber aggregate (A) is composed of metal fine wires.

5. The conductive cushion material according to any one of Claims 1 to 4, **characterized in that** said conductive filler (C) is carbon black.

6. The conductive cushion material according to Claim 5, **characterized in that** compounding amount of carbon black is 20 to 40% by weight based on total weight of said elastic resin (B) and the above carbon black.

7. A method for manufacturing the conductive cushion material according to any one of Claims 1 to 6, **characterized by** comprising the first step where an elastic resin solution is obtained by dissolving an elastic resin (B) in a solvent and added thereto a conductive filler (C), the second step where a fiber aggregate (A) composed of conductive fine wires is impregnated with the elastic resin solution and the third step where a solvent is removed from the elastic resin solution under high temperature and high humidity condition and cavities are formed in the elastic resin (B).

8. The method for manufacturing a conductive cushion material according to Claim 7, **characterized in that** the fourth step where a solvent is removed by soaking the conductive cushion material in water or hot water is further added after the above third step.

9. The method for manufacturing a conductive cushion material according to Claim 7 or 8, **characterized in that** the fifth step is further added, where the conductive cushion material is molded by a press or a hot press to adjust thickness and improve smoothness of the surface thereof.

Figure 1

## INTERNATIONAL SEARCH REPORT

| International application No. |
| --- |
| PCT/JP03/13175 |

**A. CLASSIFICATION OF SUBJECT MATTER**
Int.Cl⁷ H05K9/00, F16F15/08, C08J9/28

According to International Patent Classification (IPC) or to both national classification and IPC

**B. FIELDS SEARCHED**

Minimum documentation searched (classification system followed by classification symbols)
Int.Cl⁷ H05K9/00, F16F15/08, C08J9/28

Documentation searched other than minimum documentation to the extent that such documents are included in the fields searched
Jitsuyo Shinan Koho          1926–1996   Toroku Jitsuyo Shinan Koho    1994–2004
Kokai Jitsuyo Shinan Koho    1971–2004   Jitsuyo Shinan Toroku Koho    1996–2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 62-76113 A  (Nitta Corp.),<br>08 April, 1987 (08.04.87),<br>Page 1, lower left column, lines 11 to 15; page 2, upper left column, lines 10 to 16; page 2, upper right column, line 18 to lower left column, line 6; Fig. 1<br>(Family: none) | 1-9 |
| Y | JP 7-162185 A  (Kitakawa Kogyo Kabushiki Kaisha),<br>23 June, 1995 (23.06.95),<br>Par. Nos. [0017], [0031]<br>(Family: none) | 1-9 |

[X] Further documents are listed in the continuation of Box C.    [ ] See patent family annex.

| | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 08 January, 2004 (08.01.04) | 20 January, 2004 (20.01.04) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

**EP 1 553 813 A1**

## INTERNATIONAL SEARCH REPORT

International application No.

PCT/JP03/13175

C (Continuation). DOCUMENTS CONSIDERED TO BE RELEVANT

| Category* | Citation of document, with indication, where appropriate, of the relevant passages | Relevant to claim No. |
|---|---|---|
| Y | JP 61-176639 A (Sanyo Chemical Industries, Ltd.), 08 August, 1986 (08.08.86), Page 4, lower right column, lines 9 to 11; page 5, upper right column, lines 4 to 9; page 5, lower right column, line 9 to page 6, upper left column, line 5 (Family: none) | 7-9 |
| A | JP 2000-261107 A (Tomoegawa Paper Co., Ltd.), 22 September, 2000 (22.09.00), Par. Nos. [0017], [0031]; Figs. 1, 2 (Family: none) | 1,4-6 |
| A | JP 5-226876 A (Kitakawa Kogyo Kabushiki Kaisha), 03 September, 1993 (03.09.93), Par. No. [0016] (Family: none) | 1 |
| E,A | JP 2002-327082 A (Inoac Corp.), 15 November, 2002 (15.11.02), Par. Nos. [0013], [0018]; Fig. 1 (Family: none) | 1 |
| E,A | JP 2003-347786 A (Mitsubishi Cable Industries, Ltd.), 05 December, 2003 (05.12.03), Full text (Family: none) | 1 |
| A | JP 2000-72905 A (Kyocera Corp.), 07 March, 2000 (07.03.00), Full text; Figs. 1, 2 (Family: none) | 1 |
| A | JP 2001-126539 A (Japan Gore-Tex Inc.), 11 May, 2001 (11.05.01), Full text; Figs. 1 to 6 (Family: none) | 1 |
| A | JP 2001-85888 A (3M Innovative Properties Co.), 30 March, 2001 (30.03.01), Full text; Figs. 1 to 3 (Family: none) | 1 |
| A | JP 4-53837 A (Hayakawa Gomu Kabushiki Kaisha), 21 February, 1992 (21.02.92), Full text; Figs. 1 to 7 (Family: none) | 1 |
| A | JP 63-149131 A (Kanto Reza Kabushiki Kaisha), 21 June, 1988 (21.06.88), Full text; Figs. 1, 2 (Family: none) | 1 |

Form PCT/ISA/210 (continuation of second sheet) (July 1998)

21